# EUROPÄISCHE PATENTANMELDUNG

(11) **EP 0 644 586 A2**
(43) Veröffentlichungstag der Anmeldung: **22.03.1995**
(21) Anmeldenummer: 94112914.0
(22) Anmeldetag: 19.08.1994
(51) Int. Cl.: G01D 11/30, G01P 15/08, H01L 21/58, H01L 21/52

(54) **Anordnung zum Befestigen eines mikromechanischen Sensors auf einem Träger durch Kleben**

(30) Priorität: 17.09.1993 DE 9314084 U
(71) Anmelder: Mannesmann Kienzle GmbH, D-78052 Villingen-Schwenningen (DE)
(72) Erfinder: Schreiber-Prillwitz, Wolfgang, Dipl.-Phys., D-78056 VS-Villingen (DE); Plankenhorn, Horst, Dipl.-Ing. (FH), D-78048 VS-Villingen (DE); Lindner, Thomas, Dr. rer. nat. Phys., D-78126 Königsfeld (DE)

(57) **Zusammenfassung**

Es wird vorgeschlagen die Auflagefläche (28) des als Glas-Silizium-Glas-Schichtpaket aufgebauten Sensors (8), in dessen Siliziumschicht ein Biegeschwinger (37,38,39) herausstrukturiert ist, nur zum Teil, und zwar mittels einer genau definierten Klebefläche (33), mit dem Träger zu verkleben.

Die Abgrenzung der Klebefläche (33) und das Vermeiden von Klebstoffkriechen in außerhalb der Klebefläche (33) liegende Bereiche der Auflagefläche (29) des Sensors (8) erfolgt durch Anbringen wenigstens einer Nut (31) in der Auflagefläche (28).

## Beschreibung

Die Erfindung betrifft eine Anordnung zum Befestigen eines mikromechanischen Sensors auf einem Träger durch Kleben, wobei der Sensor vorzugsweise als Glas-Silizium-Glas-Schichtpaket mit einem in der Siliziumschicht herausstrukturierten Biegeschwinger aufgebaut ist.

Derartige Sensoren dienen im Zusammenwirken mit einer geeigneten Auswerteschaltung als Beschleunigungsgeber, wobei die Beschleunigungsmessung auf eine kapazitive Abstandsmessung zwischen einer oder zwei feststehenden Elektroden und einer beweglichen Elektrode, in diesem Falle der Masse des Biegeschwingers, zurückgeführt ist. Dieses Meßprinzip zeichnet sich bekanntlich durch eine hohe Empfindlichkeit aus. Eine zufriedenstellende Linearität und eine Kompensation temperaturbedingter Meßfehler kann durch die Anwendung des Differentialmeßverfahrens erzielt werden. Da die meßwertabhängigen Kapazitätsänderungen bei einem mikromechanischen Sensor extrem klein sind, wirken sich Einflüsse durch kondensierende Feuchtigkeit, Korrosion der Kontaktstellen der Verbindungsleitungen zwischen dem Sensor und einer Auswerteschaltung, Einstrahlungen elektrischer Felder und parasitäre Kapazitäten, die durch die erforderlichen Verbindungsleitungen verursacht werden, in erheblichem Maße nachteilig auf die Meßgenaugikeit, insbesondere die Langzeitstabilität, aus. Dementsprechend ist es, wie aus der DE-U-9202533 hervorgeht, bekannt, derartigen Beschleunigungsgebern ein hermetisch abdichtbares und elektrisch schirmendes Schutzgehäuse zuzuordnen und die Verbindungsleitungen zwischen dem Sensor und einer die Auswerteschaltung tragenden Leiterplatte so kurz wie möglich zu halten. Außerdem wurde bei dem Beschleunigungsgeber gemäß der vorstehend genannten DE-U-9202533 durch die unmittelbare Befestigung des Sensors auf einem keramischen oder einem geeigneten metallischen Träger bzw. Sockel versucht, Voraussetzungen zu schaffen, die einen nennenswerten Einfluß temperaturbedingter mechanische Spannungen auf das Meßsignal nicht mehr erwarten lassen.

Dennoch hat es sich im praktischen Betrieb gezeigt, daß die Meßsignale der in der beschriebenen Weise gefertigten Beschleunigungsgeber bei sonst gleichen Meßbedingungen nicht zufriedenstellend reproduzierbar waren und daß bei Temperaturen, beispielsweise zwischen -40^{o}C und +80^{o}C, wie sie im Kraftfahrzeug vorkommen, nicht duldbare Meßsignalabweichungen auftreten.

Es ist zu vermuten, daß die aufgetretenen Unstetigkeiten letzten Endes doch durch mechanische Spannungen verursacht werden, die sich über die abdeckende Glasschicht des Sensors in die Siliziumschicht und somit in den aktiven Bereich übertragen und das Schwingungsverhalten des Biegeschwingers beeinflussen. Dabei reichen Verformungen im am-Bereich aus, um bei der gegebenen Empfindlichkeit des Sensors deutliche Signalverfälschungen hervorzurufen. Abgesehen von den tatsächlich gegebenen Unterschieden der Temperaturkoeffizienten von Sensor und dessen Träger, müssen die Ursachen dieser mechanischen Spannungen auch in der Verbindungstechnik von Sensor und Träger zu suchen sein. Wegen der relativ kleinen Auflagefläche des Sensors von beispielsweise 50 mm² auf dem Träger werden bei der üblicherweise vorgesehenen Verbindungstechnik durch Kleben in naheliegender Weise auf der gesamten Auflagefläche des Sensors eine Mehrzahl von kleinen Klebstofftropfen aufgebracht oder eine Klebstoffspur gezogen und danach Sensor und Träger zusammengefügt. Dabei ist es denkbar, daß eine nicht vollständige Benetzung der zu verbindenden Flächen mit Klebstoff, ungleiche Klebstoffdicke und Aushärtegrade, letzten Endes aber je nach Sensorgeometrie eine relativ große Einspannlänge des Sensors, aber auch das ungleichmäßige Verlaufen des in der Regel verwendeten Mehrkomponentenklebers während der Reaktionsphase, bei der der Kleber kurzzeitig eine geringere Viskosität aufweist, die festgestellten Unstetigkeiten verursachen.

Aufgabe der vorliegenden Erfindung war es somit, die festgestellten Unwägbarkeiten beim Befestigen eines mikromechanischen Sensors zu beseitigen, wobei die vorzusehenden Maßnahmen geeignet sein müssen, großseriengerecht durchgeführt zu werden.

Die Lösung der Aufgabe ist mit dem Patentanspruch 1 dargelegt. Vorteilhafte Ausgestaltungen der Erfindung beschreiben die Unteransprüche.

Die Erfindung bietet den Vorteil, daß eine genau definierte Klebefläche von relativ geringem Ausmaß geschaffen wird. An den Grenzen dieser Klebefläche wird einerseits ein durch Kapillarkräfte verursachtes Klebstoffkriechen exakt unterbunden, andererseits kann der Klebstoffbedarf für diese Fläche relativ genau dosiert, d.h. bei einer streifenförmigen Klebefläche vorzugsweise in Raupenform oder als Tropfenreihe, bei einer punktsymmetrischen Klebefläche ggf. als ein Tropfen aufgebracht werden. Als entscheidend ist anzusehen, daß, nicht ohne Überwindung eines Vorurteils, der Sensor bezüglich seiner Auflagefläche nicht ganzflächig befestigt wird und somit auch ein Einspanneffekt, durch den Spannungen im Bereich des Biegeschwingers hervorgerufen werden können, vermieden ist. Hervorzuheben ist außerdem, daß die vorgesehenen Nute, die die Klebeflächen begrenzen, im Zuge des Fertigungsprozesses des Sensors angebracht werden können und zwar zusammen mit Einschnitten, welche dem Vereinzeln der Sensoren aus dem verbondeten Wafer-Schichtpaket dienen und mittels numerisch gesteuerter Diamant-Trennscheiben an dem Wafer-Schichtpaket angebracht werden.

Im folgenden sei die Erfindung anhand der beigefügten Zeichnungen näher erläutert.

Es zeigen
Fig. 1 ein Ausführungsbeispiel eines Beschleunigungsgebers in perspektivischer Darstellung,
Fig. 2 einen Schnitt durch den Beschleunigungsgeber gemäß Fig. 1,
Fig. 3 eine Draufsicht auf den Beschleunigungsgeber gemäß Fig. 1 mit abgenommener Abdeckung,
Fig. 4 eine Draufsicht auf die Auflagefläche eines in dem Beschleunigungsgeber gemäß Fig. 1 vorgesehenen mikromechanischen Beschleunigungssensor.

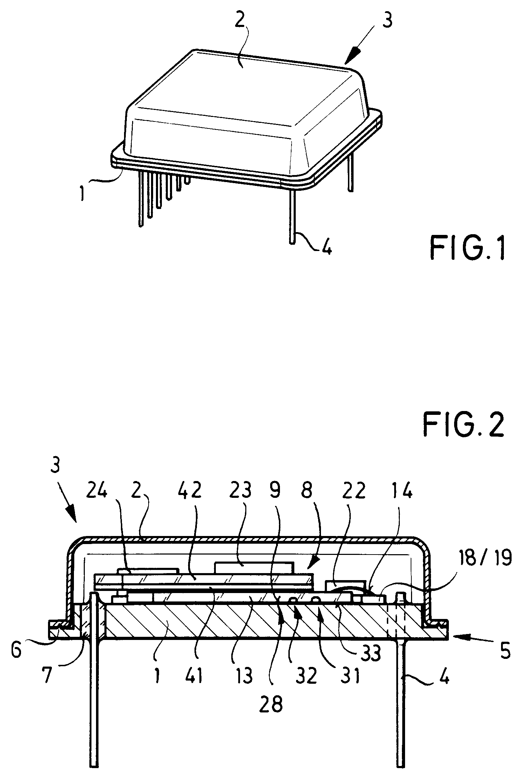

Wie aus der Fig. 1 hervorgeht, stellt der beispielsweise dargestellte Beschleunigungsgeber einen Elektronikbaustein mit einem aus einem im folgenden als Sockel bezeichneten Träger 1 und einer Abdeckung 2 bestehenden Gehäuse 3 dar. Im Sockel 1 befestigte Kontaktstifte, von denen einer mit 4 bezeichnet ist, dienen zusätzlich der unmittelbaren Befestigung des Gehäuses 3, beispielsweise auf einer Leiterplatte eines Gerätes. Bei dem dargestellten Gehäuse 3 bestehen Sockel 1 und Abdeckung 2 aus Metall, haben somit schirmende Wirkung gegenüber einstrahlenden elektrischen Feldern und sind an einem beiderseits ausgebildeten Rand 5, vorzugsweise unter Zwischenschaltung einer umlaufenden Rippe 6, miteinander verschweißt und ggf. schutzgasgefüllt. Die Kontaktstifte 4 sind, wie Fig. 2 zeigt, beispielsweise mittels einer Glasmasse 7 als Isolierung im Sockel 1, der vorzugsweise aus Stahl mit der Warenbezeichnung KOVAR hergestellt ist, eingebettet. Der Sockel 1 oder beide Gehäuseteile können auch aus Keramik hergestellt und, wenn die Schirmung gegen elektrische Felder erforderlich ist, metallisiert sein.

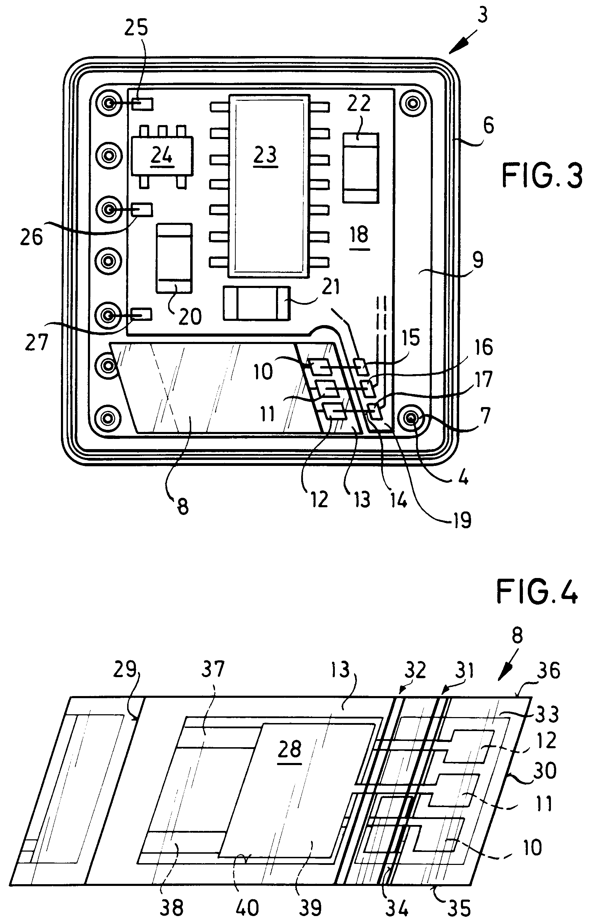

Die Fig. 2 und 3 zeigen ferner einen mit 8 bezeichneten, vorzugsweise als Differentialkondensator ausgebildeten mikromechanischen Sensor, welcher unmittelbar auf einer Innenfläche 9 des Sockels 1 durch Kleben befestigt ist. Wie bereits eingangs erwähnt, besteht der Sensor 8 aus einem Glas-Silizium-Glas-Schichtpaket, bei dem das kräftesensierende Element als Biegeschwinger aus der Siliziumschicht herausstrukturiert ist. Mit 10, 11 und 12 sind vorzugsweise auf einer Glasschicht 13 des Sensors 8 nebeneinander angeordnete, den nicht dargestellten Elektroden des Sensors 8 zugeordnete Anschlußkontakte bezeichnet. Diese sind mittels angebondeter Drähte - einer ist mit 14 bezeichnet - mit Kontakten 15, 16 und 17 verbunden, welche sich auf einer als Schaltungsträger dienenden Leiterplatte 18 bzw. einer an dieser ausgebildeten Zunge 19 befinden. Die Leiterplatte 18 trägt die für die Auswertung der von dem Sensor 8 gelieferten Signale erforderlichen elektronischen Bauelemente, nämlich Widerstände 20, 21 und 22, ein Mehrfachgatter 23 und ein weiteres Gatter 24. Der Einfachheit halber sind die auf der Leiterplatte 18 aufgebrachten Leiterbahnen nicht vollständig dargestellt. Von den Kontakten 25, 26 und 27 dienen zwei dem Anlegen der Versorgungsspannung, während einer das Meßsignal führt.

Die Draufsicht auf die Auflagefläche 28 des Sensors 8 zeigt gemäß Fig. 4, daß parallel zu den die Auflagefläche 28 in der einen Dimension begrenzenden Kanten 29 und 30 zwei Nute 31 und 32 in der Glasschicht 13 eingeschnitten sind. Dabei grenzt die Nut 31 die eigentliche Klebefläche 33 innerhalb der Auflagefläche 28 ab, während die Nut 32 als zusätzliche Stoppstruktur für den Fall dient, daß überschüssiger Klebstoff beim Zusammenfügen über die Nut 31 hinausquillt oder auf andere Art und Weise über die Nut 31 hinwegverschleppt wird. Da es für die beabsichtigte Funktion lediglich auf eine Unterbrechung des Kapillareffektes im Klebespalt zwischen Sensor 8 und Sockel 1 ankommt, können die Nute 31 und 32 relativ flach, ggf. auch unterschiedlich tief, ausgebildet sein, so daß keine nennenswerte Schwächung der Glasschicht 13 eintritt.

Die Klebefläche 33 ist gemäß der Fig. 4 durch die Kante 30, eine durch die Nut 31 gebildete Kante 34 und durch die Auflagefläche 28 quer zu den Kanten 29 und 30 begrenzende Kanten 35 und 36 bestimmt. Da die Masse des Sensors 8 es zuläßt, den Sensor 8 mit einer noch kleineren Klebefläche mit ausreichender Sicherheit zu befestigen. ist es denkbar, lediglich eine Ecke oder ein durch sich schneidende Nute gebildeter zentraler Klebebereich als Klebeflächen auszubilden. Ebenso ist es denkbar, die Klebefläche innerhalb der Innenfläche 9 des Sockels 1 bzw. innerhalb der sockelseitigen Auflagefläche des Sensors 8 auszubilden. Jedoch ist es in diesem Falle nicht möglich Außenkanten zu nützen und die erforderlichen Nute 31 und 32 während eines ohnehin erfolgenden Schneidprozesses mitzuschneiden.

Der Vollständigkeit halber sei noch die nicht erfindungswesentliche Tatsache erwähnt, daß für die Herstellung des Sensors 8, wie die rautenförmigen Konturen erkennen lassen, 110-orientierte Silizium-Wafer verwendet werden. Dadurch kann der Vorteil der anisotropen Ätztechnik, nämlich ein erheblich schnelleres Ätzen rechtwinklig zur Schichtfläche und die sich daraus ergebenden konstruktiven Möglichkeiten genutzt werden. Ferner ist die Bauform des Sensors 8 derart gewählt, daß beim Vereinzeln der Sensoren aus dem verbondeten Wafer-Schichtpaket Konsolen mit von einer Seite aus zugänglichen nebeneinanderliegenden Kontakten 10, 11, 12 entstehen. In Fig. 4 ist gegenüber der Fig. 3 der Biegeschwinger des Sensors 8, d.h. eine an zwei Armen 37 und 38 aufgehängte Masse 39 sowie der Bewegungsraum 40 dargestellt. Auf die Darstellung der der Masse 39 zugeordneten Elektroden, welche jeweils einer der die Siliziumschicht 41 (Fig. 2) abdeckenden Glasschicht 13 bzw. 42 zugeordnet sind sowie deren Verbindungsleitungen zu den Kontakten 10, 11, 12, wurde der Übersichtlichkeit halber verzichtet.

Das angestrebte maschinelle Verfahren zur Befestigung des Sensors 8 auf dem Sockel 1 ist insbesondere dadurch gekennzeichnet, daß der Klebstoff mittels eines geeigneten Dispensers in Form von Klebstoffraupen bzw. Punktreihen nach einem festgelegten Klebebild bzw. einer Klebefigur auf dem Sockel 1 aufgebracht wird. Das heißt, es werden, wenn der aus einem Magazin zugeführte Sockel 1 oder eine Mehrzahl von Sockeln ausgerichtet sind, beispielsweise zwei parallele Klebstoffraupen für die Befestigung der Leiterplatte 18 und eine Klebstoffraupe, die der Klebefläche 33 des Sensors 8 zugeordnet ist, mittels des Dispensers aufgebracht. Danach erfolgt lediglich ein positionsgerechtes Aufsetzen von Sensor 8 und Leiterplatte 18, bevor die so vorbereiteten Sockel zur Aushärtung des Klebstoffs einem geeigneten Ofen zugeführt und danach die Beschleunigungsgeber komplettiert werden.

## Patentansprüche

1. Anordnung zum Befestigen eines mikromechanischen Sensors auf einem Träger durch Kleben, wobei der Sensor vorzugsweise als Glas-Silizium-Glas-Schichtpaket mit einem
in der Siliziumschicht herausstrukturierten Biegeschwinger aufgebaut ist,
dadurch gekennzeichnet,
daß innerhalb des Kontaktbereichs zwischen Sensor und Träger eine der Auflageflächen durch wenigstens eine Nut derart unterbrochen ist,
daß, bezogen auf die schichtparallele Auflagefläche des Sensors, eine kleinere Klebefläche freigestellt ist.

2. Anordnung nach Anspruch 1,
dadurch gekennzeichnet,
daß die Klebefläche (33) durch eine an dem Sensor (8) eingeschnittene Nut (31) ausgebildet ist.

3. Anordnung nach Anspruch 1,
dadurch gekennzeichnet,
daß die Klebefläche (33) außerhalb eines Bereichs der Auflagefläche (28) liegt, welcher dem schichtparallelen Querschnitt des für den Biegeschwinger (37, 38, 39) vorgesehenen Bewegungsraumes (40) des Sensors (8) deckungsgleich gegenüberliegt.

4. Anordnung nach Anspruch 1,
dadurch gekennzeichnet,
daß die Nute (31) im Zuge des Herstellprozesses der Sensoren (8) insbesondere während des Anbringens von der Vereinzelung der Sensoren (8) aus einem Wafer-Schichtpaket dienenden Trennschnitten mitgeschnitten werden.

5. Anordnung nach Anspruch 1,
dadurch gekennzeichnet,
daß die Klebefläche von zwei Außenkanten der Auflagefläche (28) des Sensors (8) und wenigstens einer Nut begrenzt ist.

6. Anordnung nach Anspruch 1,
dadurch gekennzeichnet,
daß die Klebefläche (33) von drei Außenkanten (34, 35, 36) und einer Nut (31) begrenzt ist.

7. Anordnung nach Anspruch 1,
dadurch gekennzeichnet,
daß die Klebefläche von im wesentlichen paarweise parallelen Nuten begrenzt ist.

8. Anordnung nach Anspruch 1,
dadurch gekennzeichnet,
daß die Nut (31) innerhalb der Auflagefläche des Sensors (8) auf dem Träger (1) im Träger (1) ausgebildet ist.
